# EUROPEAN PATENT APPLICATION

(11) **EP 4 575 591 A1**
(43) Date of publication of application: **25.06.2025**
(21) Application number: 23219624.6
(22) Date of filing: 22.12.2023
(51) Int. Cl.: G02B 1/00, G02B 5/18, G02B 27/30, G02B 27/10, G02B 19/00

(54) **AN OPTICAL METAMATERIAL-BASED COLOR COMBINER**

(71) Applicant: Imec VZW, 3001 Leuven (BE)
(72) Inventor: Rottenberg, Xavier, 3010 Kessel-Lo (BE); Pejovic, Vladimir, 3000 Leuven (BE); Genoe, Jan, 3272 Testelt (BE); Figeys, Bruno, 3001 Heverlee (BE); Gehlhaar, Robert, 3020 Herent (BE)
(74) Representative: Roth, Sebastian

(57) **Abstract**

The present disclosure relates to the collimation of optical beams generated by an array of emission pixels. The disclosure proposes an integrated optical system that comprises an array of emission pixels and a metamaterial having a plurality of subwavelength structures, wherein the metamaterial comprises a plurality of collimation regions. A first collimation region is configured to collimate respectively a first part of a first optical beam and a second part of a second optical beam having different wavelengths. A second collimation region is configured to collimate respectively a second part of the first optical beam and a first part of the second optical beam. The collimation includes diffracting said parts based on a distribution of the plurality of subwavelength structures, wherein the parts of the first optical beam are combined, and wherein the parts of the second optical beam are combined.

## Description

### TECHNICAL FIELD

The present disclosure relates to the collimation of optical beams generated by an array of emission pixels. The disclosure proposes an integrated optical system. The optical system comprises an array of emission pixels that generate optical beams which are collimated.

### BACKGROUND

In the field of augmented reality (AR) and virtual reality (VR) small size pixel pitch of displays, representing the spatial separation between adjacent pixels on a display, is crucial for visual quality and immersive experience. The driving motivation behind reducing pixel pitch is to enhance visual acuity and rendering quality. As AR|VR devices are intended to be used in close proximity to the eyes, it is vital to diminish the so called "screen door effect", a phenomenon wherein the inter-pixel gaps become observable. In addition, light intensity of these displays is important for user experience, especially for outdoor AR applications.

However, it is challenging to simultaneously achieve the requirements of small pixel pitch and high brightness.

### SUMMARY

In view of the above, an objective of this disclosure is to improve the pixel density and/or the visualization quality of optical systems. In particular, an objective is to improve the brightness and pixel pitch of said optical systems by improving optical beam gathering in high-pixel-density displays.

These and other objectives are achieved by this disclosure as described in the independent claims. Advantageous implementations are further defined in the dependent claims.

The solutions of this disclosure are further based on the following considerations.

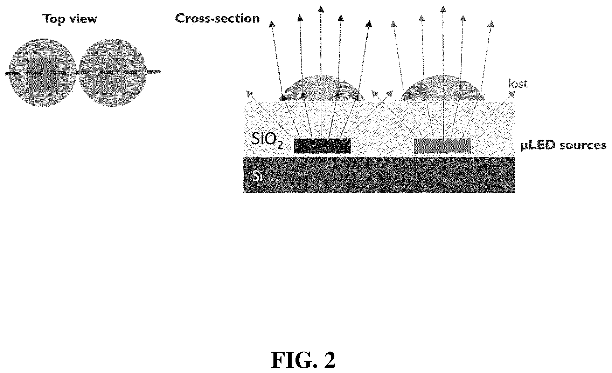

FIG. 2 shows conventional collimation lenses. To gather light emitted by light sources, collimating lenses can be placed above the light sources. However, conventional collimating lenses cannot capture light emitted at wide angles. Due to the size constraints in small-pixel-pitch displays, lens arrays that can be fabricated above the light sources cannot effectively capture all of the light, and certain portions are inevitably lost, for example, the outer rays shown in FIG. 2. Hence, the brightness is reduced due to the incomplete light gathering in high-pixel-density displays.

Thus, providing lenses or materials that can simultaneously collimate optical beams emitted from different emission pixels could improve optical beam gathering in high-pixel-density displays.

Among different conventional display technologies, the emerging µLED technology based on compound semiconductors may be a promising candidate to deliver the necessary pixel density and luminosity required for, for example, AR and VR displays.

A first aspect of this disclosure provides an integrated optical system comprising: an array of emission pixels, each emission pixel being configured to emit a respective optical beam having a respective wavelength, a controller configured to control the array of emission pixels to emit two or more optical beams by using two or more emission pixels, and an optical metamaterial having a plurality of subwavelength structures, wherein the plurality of subwavelength structures comprises at least two distinct materials having different refractive indices, wherein the optical metamaterial comprises a plurality of collimation regions, each collimation region being associated with one respective emission pixel of the array of emission pixels, wherein the plurality of collimation regions are arranged to receive the two or more optical beams from the array of emission pixels, and wherein a first collimation region of the plurality of collimation regions is configured to collimate respectively a first part of a first optical beam of the two or more optical beams and a second part of a second optical beam of the two or more optical beams by diffracting the first part of the first optical beam and the second part of the second optical beam based on a distribution of the plurality of subwavelength structures in the first collimation region, wherein a second collimation region of the plurality of collimation regions is configured to collimate respectively a second part of the first optical beam and a first part of the second optical beam by diffracting the second part of the first optical beam and the first part of the second optical beam based on a distribution of the plurality of subwavelength structures in the second collimation region, wherein the first part of the first optical beam and the second part of the first optical beam are thereby combined to form at least a part of a first collimated optical beam, wherein the first part of the second optical beam and the second part of the second optical beam are thereby combined to form at least a part of a second collimated optical beam, and wherein the first optical beam and the second optical beam have different respective wavelengths.

Collimating said parts of the first optical beam and the second optical beam may further comprise refracting said parts based on the refractive indices of the at least two materials.

The plurality of subwavelength structures may be formed or defined by a physical distribution of the at least two distinct materials in the metamaterial, wherein each subwavelength structure may comprise one, for example, only one, distinct material of the at least two distinct materials. For example, a first material of the at least two distinct materials that, for example, forms a first material island, and is surrounded by at least a second material of the at least two distinct materials may be considered to be a first subwavelength structure of the plurality of subwavelength structures. For example, the second material of the at least two distinct materials that, for example, forms a second material island, and is surrounded by at least the first material may be considered to be a second subwavelength structure of the plurality of subwavelength structures.

For example, the at least two distinct materials may comprise at least one of Si₃N₄, SiO₂, and TiO₂.

Each subwavelength structure of the plurality of subwavelength structures may be smaller than a wavelength of an optical beam, for example, any optical beam, emitted by the array emission pixels.

The distribution of the plurality of subwavelength structures in the plurality of collimation regions, for example, the distribution of the plurality of subwavelength structures in the first collimation region, may be determined and/or arranged based on machine learning algorithms. A machine learning algorithm may design said distributions based on the requirements of collimating the respective parts of the two or more optical beams and/or other optical beams emitted by the array of emission pixels.

Each subwavelength structure of the plurality of subwavelength structures may or may not have an abstract shape. Said shapes may be respectively one-dimensional, two-dimensional, or three-dimensional.

The optical metamaterial may be divided or partitioned into the plurality of collimation regions. For example, the plurality of collimation regions may form an array of collimation pixels.

The plurality of collimation regions may act as partially wavelength independent lenses.

The plurality of collimation regions may be non-overlapping. The first collimation region and the second collimation region may be non-overlapping. The first collimation region and the second collimation region may be adjacent, for example directly adjacent. The plurality of collimation regions may be a one-dimensional or a two-dimensional array of collimation regions. The plurality of collimation regions may be arranged regularly, for example, having the same distances between collimation regions, or irregularly.

The array of emission pixels may be a one-dimensional or a two-dimensional array of emissions pixels. The array of emission pixels may be arranged regularly, for example, having the same distances between emission pixels, or irregularly.

The arrangement of the array of emission pixels may define a first plane and an arrangement of the plurality of collimation regions may define a second plane, wherein the first plane and the second plane may be parallel to each other.

Each optical beam of the two or more optical beams may be monochromatic. Each emission pixel of the array of emission pixels may be configured to emit a respective monochromatic optical beam having a respective wavelength.

The optical system may comprise a display, for example a micro light-emitting diode (LED) display. For example the display may comprise the array of emission pixels. The display may or may not comprise the metamaterial.

The term 'integrated' in the context of the optical system may denote a cohesive design where various optical components, for example, optical beam sources, lenses, collimation regions, and detectors, are combined into a unified assembly. This integration, for example, achieved through monolithic or hybrid methods, may enhance the system's functionality. It may offer advantages such as miniaturization, improved reliability, and cost efficiency. Specifically, for a system with a pixel array emitting optical beams, this integration may allow for precise optical beam control at the pixel level, potentially enhancing imaging or communication applications. The term 'integrated' covers various design approaches, emphasizing flexibility and efficiency in the optical system's operation.

Based on the optical system, different emission pixels can be used to emit optical beams having different wavelengths. The two optical beams having different wavelengths can be then collimated into two collimated beams by one collimation region that is associated with one emission pixel. The two optical beams having different wavelengths can further be collimated into the two collimated beams by another collimation region.

Thus, a bigger portion of the first optical beam and the second optical beam can be collimated. Thus, the brightness can be increased and/or a high-density array of emission pixels can be used without the above mentioned drawbacks.

In an implementation form of the first aspect, each collimation region of the plurality of collimation regions is centered above the respective emission pixel that is associated with the collimation region.

Each collimation region of the plurality of collimation regions may be placed at a certain distance above the respective emission pixel that is associated with the collimation region.

In a further implementation form of the first aspect, the first optical beam is emitted from a respective emission pixel that is associated with the first collimation region, wherein the second optical beam is emitted from a respective emission pixel that is associated with the second collimation region, and wherein the respective emission pixel that is associated with the second collimation region is adjacent, for example, directly adjacent, to the respective emission pixel that is associated with the first collimation region.

The respective emission pixel that is associated with the first collimation region may be a first emission pixel.

The respective emission pixel that is associated with the second collimation region may be a second emission pixel.

The two or more optical beams may be three or more optical beams and may comprise a third optical beam. The first collimation region may be further configured to collimate a second part of a third optical beam, by diffracting the second part of the third optical beam based on the distribution of the plurality of subwavelength structures in the first collimation region. The second part of the third optical beam may thereby be combined with a first part of the third optical beam to form at least a part of a third collimated optical beam.

The third optical beam may be generated by a third emission pixel that is associated with a third collimation region of the plurality of collimation regions. The third emission pixel may be adjacent, for example, directly adjacent, to the first emission pixel. The third optical beam and the first optical beam may or may not have the same wavelength, for example, the same central wavelength or the same entire frequency spectrum. The first optical beam and the third optical beam may have different angles of incidence on the first collimation region.

Collimating said parts of the third optical beam may further comprise refracting said parts based on the refractive indices of the at least two materials.

In a further implementation form of the first aspect, the plurality of collimation regions are arranged such that, for each emission pixel of the array of emission pixels, the respective optical beam emitted by the respective emission pixel is primarily collimated by the collimation region that is associated with the respective emission pixel.

For example, the first optical beam may be primarily collimated by the first collimation region. The second collimation region may be primarily collimated by the second collimation region. The third collimation region may be primarily collimated by the third collimation region.

The term primarily may refer to, for example, a majority of the first optical beam being collimated by the first collimation region. The term majority or the term primarily may refer to a majority of the optical power of an optical beam, for example, the first optical beam, being collimated by a respective collimation region, for example, the first collimation region.

In a further implementation form of the first aspect, the plurality of collimation regions are arranged such that the first part of the first optical beam and the second part of the second optical beam have different angles of incidence on the first collimation region.

Thus, the distribution of the plurality subwavelength structures in the first collimation region may be configured based on said different angles of incidence.

In a further implementation form of the first aspect, the plurality of collimation regions are arranged such that the second part of the first optical beam and the first part of the second optical beam have different angles of incidence on the second collimation region.

Thus, the distribution of the plurality subwavelength structures in the second collimation region may be configured based on said different angles of incidence.

In a further implementation form of the first aspect, the distribution of the plurality of subwavelength structures in the first collimation region and/or the refractive indices of the at least two distinct materials is/are configured based on estimated respective angles of incidence of the first part of the first optical beam and the second part of the second optical beam on the first collimation region.

Said angles of incidence may be estimated based on: (i) the geometric relationship between the first emission pixel and the first collimation region, (ii) the geometric relationship second emission pixel and the first collimation region, (iii) an emission angle of the first emission pixel, and (iv) an emission angle of the second emission pixel.

In a further implementation form of the first aspect, the distribution of the plurality of subwavelength structures in the second collimation region and/or the refractive indices of the at least two distinct materials is/are configured based on estimated respective angles of incidence of the first part of the second optical beam and the second part of the first optical beam on the second collimation region.

Said angles of incidence may be estimated based on: (i) the geometric relationship between the first emission pixel and the second collimation region, (ii) the geometric relationship second emission pixel and the second collimation region, (iii) an emission angle of the first emission pixel, and (iv) an emission angle of the second emission pixel.

In general, the angles of incidence may be estimated based on the geometric relationship between the array of emission pixels and the plurality of collimation regions.

In a further implementation form of the first aspect, the distribution of the plurality of subwavelength structures in the first collimation region and/or the refractive indices of the at least two distinct materials is/are configured based on the respective wavelengths of the first optical beam and the second optical beam.

Thus, the metamaterial can be effectively optimized for collimating the two or more optical beams.

In a further implementation form of the first aspect, the distribution of the plurality of subwavelength structures in the first collimation region is irregular, and/or the distribution of the plurality of subwavelength structures in the first collimation region comprises two or more different periodicities.

In a further implementation form of the first aspect, the distribution of the plurality of subwavelength structures in the second collimation region is irregular, and/or the distribution of the plurality of subwavelength structures in the second collimation region comprises two or more different periodicities.

For example, by determining the distribution of the plurality of subwavelength structures in the metamaterial, for example, in the first collimation region, with a machine learning algorithm highly complex and/or irregular distributions may be obtained. Said distributions may include two or more different periodicities. For example, said two or more different periodicities may be not easily detectable due to the complexity of the distribution.

In a further implementation form of the first aspect, a first periodicity of the two or more different periodicities of the first collimation region is configured based on the first part of the first optical beam, and a second periodicity of the two or more different periodicities of the first collimation region is configured based on the second part of second optical beam.

The two or more different periodicities may be three or more different periodicities. A third periodicity of the three or more different periodicities of the first collimation region may be configured based on the second part of third optical beam.

For example, the first periodicity may be configured based on and angle of incidence and/or wavelength of the first part of the first optical beam.

For example, the second periodicity may be configured based on and angle of incidence and/or wavelength of the second part of the second optical beam.

Similarly, two or more different periodicities of the second collimation region may be configured based on the second part of the first optical beam and the first part of the second optical beam.

In general, a respective periodicity of the plurality of subwavelength structures may be configured based on respective parts of the two or more optical beams.

Respective periodicities may be configured to specifically diffract the respective parts of the two or more optical beams.

A respective periodicities may be considered to represent a receptive diffractive grating for the respective part of an optical beam of the two or more optical beams. Thus, a diffraction and collimation of multiple of the two or more optical beams may be tuned simultaneously based on the metamaterial.

In a further implementation form of the first aspect, the first collimation region is arranged to receive only the first part of the first optical beam and only the second part of the second optical beam.

For example, every part of the two or more optical beams that the first collimation region receives may be collimated, for example, respectively collimated.

In a further implementation form of the first aspect, the second collimation region is arranged to receive only the first part of the second optical beam and only the second part of the first optical beam.

For example, every part of the two or more optical beams that the second collimation region receives may be collimated, for example, respectively collimated.

Thus, the metamaterial may efficiently collimate the two or more optical beams, for example, the first optical beam and the second optical beam.

In a further implementation form of the first aspect, the plurality of collimation regions are arranged abuttingly.

The plurality of collimation regions may be non-overlapping.

The array of emission pixels may be arranged abuttingly or non-overlapping.

In a further implementation form of the first aspect, at least one of: a thickness of the metamaterial is in a range of 0.1 to 10 times a wavelength of each of the two or more optical beams; and a size of each subwavelength structure of the plurality of subwavelength structures, for example, a maximum size in any direction, is in a range of 10 nm to 1000 nm.

In a further implementation form of the first aspect, the metamaterial comprises two or more layers comprising the plurality of subwavelength structures.

The thickness of each layer may be on the scale of a wavelength of a respective optical beam, for example, of any optical beam, emitted by the array of emission pixels.

In this disclosure, the term on the scale of a wavelength may refer the range of 1/10 to 10 times said wavelength.

The entire thickness of the metamaterial may be a larger than a wavelength of a respective optical beam, for example, of any optical beam, emitted by the array of emission pixels.

In a further implementation form of the first aspect, each layer is thinner than each other layer that is closer to a side of the metamaterial that is arranged to receive the two or more optical beams.

An nth layer may receive the two or more optical beams as the N^{th} layer in temporal order. For example, a first layer may receive the two or more optical beams first and/or a second layer may receive the two or more optical beams second.

For example, a N^{th} layer may be thicker then a N+1^{th} layer. Thus, the metamaterial may be more efficient.

Thus, the metamaterial may be more efficient and/or may be capable of collimating more optical beams with different angles of incidence and/or wavelengths.

In a further implementation form of the first aspect, one or more surfaces of the metamaterial that face away from the array of emission pixels define a plane having a normal vector, wherein the distribution of the plurality of subwavelength structures in the first collimation region and/or the refractive indices of the at least two distinct materials is/are configured such that the first collimated optical beam is provided from the metamaterial at an angle to the normal vector that is larger than 0°.

The plane may be or be parallel to the first plane and/or the second plane. For example, the plane may be the second plane.

The angle at which a collimated optical beam, for example, the first collimated optical beam, may be directed can be configured based on the metamaterial, for example, based on the distribution of the plurality of subwavelength structures.

Thus, the optical system can be flexibly fabricated for additional applications. For example, an application of the optical system may have high requirements in terms of size such that directly providing the collimated beams into a predefined direction may be required.

In a further implementation form of the first aspect, the angle of the first collimated optical beam is a first angle, and the distribution of the plurality of subwavelength structures in the second collimation region and/or the refractive indices of the at least two distinct materials is/are configured such that the second collimated optical beam is provided from the metamaterial at a second angle to the normal vector that is 0° or larger than 0°.

The first angle and the second angle may or may not be different angles.

For example, the first angle may be in a range of 5° to 85°. The second angle may be in a range of 0° to 90°, for example, 5° to 85°.

Thus, different collimated beams may be directed in the same direction and/or different collimated beams may be directed in different directions.

Further, in this disclosure, a first element and a second element are considered to be different elements, if not explicitly mentioned otherwise. For example, the first optical beam and the second optical beam are considered to be different optical beams, they are at least different because of the different frequency, but further also as they form part of different optical beams emitted by different emission pixels. For example, the first part of the first optical beam and the second part of the first optical beam are considered to be different parts of the first optical beam. For example, the first part of the second optical beam and the second part of the second optical beam are considered to be different parts of the second optical beam. For example, the first collimation region and the second collimation region are considered to be different collimation regions.

Further, in this disclosure, the phrase "above" when referring to a physical location may refer to a vertical direction, wherein the direction in which the array of emission pixels emits the two or more optical beams may be parallel to the vertical direction. The vertical direction may be a direction perpendicular to the arrangement of the array of emission pixels, wherein the arrangement of the array of emission pixels may be considered to form a plane, for example, the first plane, comprising all of the emission pixels of the array of emission pixels. For example each emission pixel may comprise an emission surface that faces towards the vertical direction, wherein each emission surface may be parallel to the plane.

"Above " and " below ", as used herein, are defined with respect to a "body-fixed" reference frame/coordinate system, i.e. a reference frame that is fixed to the optical system and rotates with the latter in case the latter is rotated.

Further, in this disclosure, forming or providing a layer or element "on" another layer or element may mean growing/depositing these layers or elements one upon the other. Thus, surfaces of these layers or elements may be in contact.

### BRIEF DESCRIPTION OF DRAWINGS

The above described aspects and implementation forms will be explained in the following description of specific embodiments in relation to the enclosed drawings, in which
- FIG. 1: shows an integrated optical system according to this disclosure.
- FIG. 2: shows conventional collimation lenses.
- FIG. 3: shows a cross-section of an optical system according to this disclosure.
- FIG. 4: shows an exemplary metamaterial according to this disclosure.

### DETAILED DESCRIPTION OF EMBODIMENTS

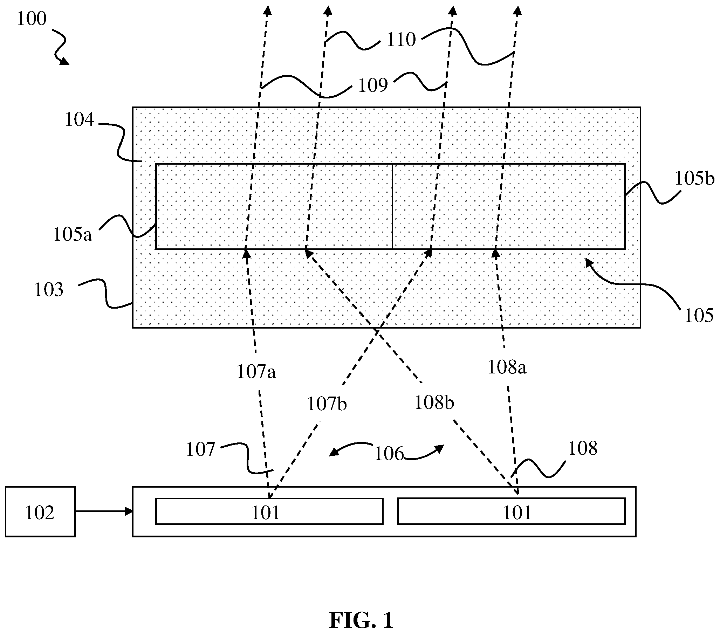

FIG. 1 shows an optical system 100 according to this disclosure. The integrated optical system 100 comprises an array of emission pixels 101, a controller 102, and an optical metamaterial 103 having a plurality of subwavelength structures 104.

Generally, each emission pixel of the array of emission pixels 101 is configured to emit a respective optical beam having a respective wavelength, wherein the controller 102 is configured to control the array of emission pixels 101 to emit two or more optical beams 106 by using two or more emission pixels.

The two or more optical beams 106 comprise a first optical beam 107 and a second optical beam 108, wherein the first optical beam 107 and the second optical beam 108 have different respective wavelengths. The first optical beam 107 comprises a first part 107a and a second part 107b. The second optical beam 108 comprises a first part 108a and a second part 108b. For example, the first optical beam 107 may be generated by a first emission pixel 101a of the array of emission pixels 101 and the second optical beam 108 may be generated by a second emission pixel 101b array of emission pixels 101 that is different from the first emission pixel 101a.

The optical metamaterial 103 comprises a plurality of collimation regions 105, wherein each collimation region is associated with one respective emission pixel of the array of emission pixels 101. The plurality of collimation regions 105 are arranged to receive the two or more optical beams 106 from the array of emission pixels 101.

A first collimation region 105a of the plurality of collimation regions 105 is configured to collimate respectively the first part 107a of the first optical beam 107 of the two or more optical beams 106 and the second part 108b of the second optical beam 108 of the two or more optical beams 106 by diffracting the first part 107a of the first optical beam 107 and the second part 108b of the second optical beam 108 based on a distribution of the plurality of subwavelength structures 104 in the first collimation region 105a. The first part 107a of the first optical beam 107 may comprise a majority of the optical power of the first optical beam 107, as it is for example placed directly above the corresponding emission pixel, or for example captures most of the optical beam emitted by that emission pixel.

A second collimation region 105b of the plurality of collimation regions 105 is configured to collimate respectively the second part 107b of the first optical beam 107 and the first part 108a of the second optical beam 108 by diffracting the second part 107b of the first optical beam 107 and the first part 108a of the second optical beam 108 based on a distribution of the plurality of subwavelength structures 104 in the second collimation region 105b. The first part 108a of the second optical beam 108 may comprise a majority of the optical power of the second optical beam 108.

The first part 107a of the first optical beam 107 and the second part 107b of the first optical beam 107 are thereby combined to form at least a part of a first collimated optical beam 109. Further, the first part 108a of the second optical beam 108 and the second part 108b of the second optical beam 108 are thereby combined to form at least a part of a second collimated optical beam 110. FIG. 1 indicates that said parts are combined into respectively the part of the first collimated optical beam 109 and the part of the second collimated optical beam 110 by dashed arrows.

Generally, and the plurality of subwavelength structures 104 comprises at least two distinct materials having different refractive indices.

The at least two distinct materials may form the plurality of subwavelength structures 104 based on their distribution. For example, a first material of the at least two distinct materials that forms a material island and is surrounded by a second material of the at least two distinct materials may be considered to be a first subwavelength structure of the plurality of subwavelength structures 104.

The optical system 100 can increase brightness and concentrate emitted optical beams of, for example, high-pixel-density displays. Thus, the optical system 100 may be suitable for AR|VR applications. When pixel pitch is small, for example, when optical beam sources emitting optical beams at different wavelengths are close to each other, it is challenging to gather and collimate light emitted at wide angles which compromises brightness and image quality. A flat optic element or a metamaterial can be used, which can gather optical beams emitted at wide angles and combine them into a single collimated beam. Such a collimating element can be designed for multiple different wavelengths, analogous but opposite to color splitters used for imaging.

Conceptually, larger lenses could be fabricated to capture a broader cone of light emitted by emission pixels having large etendue. However, such overlapping lenses would not work in practice, as, for example, the pixel pitch would increase to maintain spacing between the lenses, and thus for example the brightness would decrease.

In this disclosure a similar functionality can be achieved with flat optic elements or metamaterials. Optical metamaterials comprise subwavelength structures, typically made of at least two materials of distinct refractive indices. Optical metamaterials can be used to manipulate intensity, phase or polarization of optical beams.

Generally, flat lenses, polarizers, filters and other optical components are more compact compared to their conventional refractive counterparts. The concept of metamaterials can be applied to design an optical element which simultaneously collects and collimates optical beams of different colors or wavelengths.

The optical system 100 may or may not comprise an intermediate layer 111. The array of emission pixels 101 may be embedded in the intermediate layer 111 and/or the intermediate layer 111 may be provided on the array of emission pixels 101. The intermediate layer 111 may be configured to provide each respective optical beam generated by the array of emission pixels 101 to the metamaterial 103. The intermediate layer 111 and/or the array of emission pixels 101 may be provided on a substrate 112.

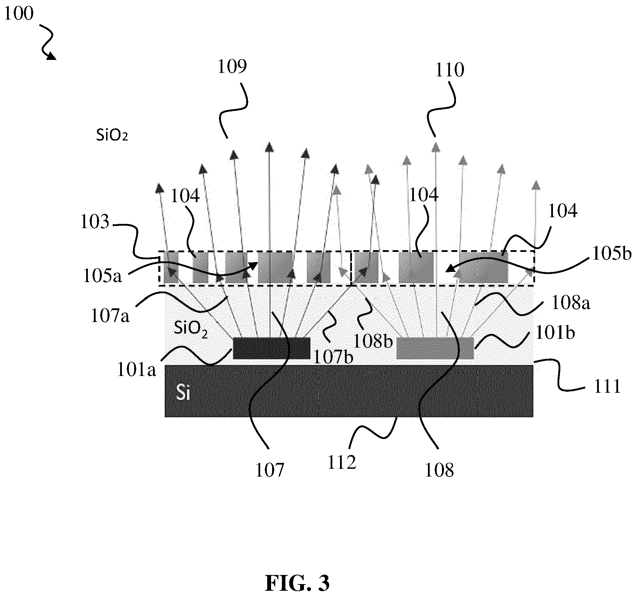

FIG. 3 shows a cross-section of an optical system 100 according to this disclosure. The optical system 100, for example, the optical system 100 shown in FIG. 1, comprises a metamaterial 103, which comprises a plurality of subwavelength structures 104. In this example, an intermediate layer 111 comprising SiO₂ is provided on the array of emission pixels 101, wherein the metamaterial 103 is provided on the intermediate layer 111, and wherein the intermediate layer 111 and/or the array of emission pixels 101 are provide on the substrate 112, which comprises Si. The controller 102 is not shown.

FIG. 3 shows an exemplary first optical beam 107 generated by a first emission pixel 101a, and an exemplary second optical beam 108 generated by a second emission pixel 101b. In this example, the area occupied by the first optical beam 107 and the area occupied by the second optical beam 108 is respectively indicated by arrows extending form the first emission pixel 101a and the second emission pixel 101b, wherein respectively the arrows located at the most outer positions respectively indicate the boundaries of the respective beams.

The metamaterial 103 can be divided or partitioned, for example, conceptually divided, into a plurality of collimation regions 105. The division of the metamaterial 103 into a first collimation region 105a and a second collimation region 105b is indicated by dashed boxes in FIG. 3.

FIG. 3 shows that the outer parts of the first optical beam 107 and the outer parts of the second optical beam 108 spatially overlap at the plurality of collimation regions 105, which is indicated by the arrows located at the most outer positions. The first collimation region 105a receives a second part 108b of the second optical beam 108 and the second collimation region 105b receives a second part 107b of the first optical beam 107. Further, FIG. 3 shows that the majority of the first optical beam 107 or a first part 107a of the first optical beam 107 is received by the first collimation region 105a, wherein the majority of the second optical beam 108 or a first part 108a of the second optical beam 108 is received by the second collimation region 105b.

A part of the first collimation region 105a that receives the first part 107a of the first optical beam 107 and the second part 108b of the second optical beam 108, for example, the part of the first collimation region 105a where said parts overlap, may be configured to collimate both of said parts 107a, 108b of the optical beams 107, 108.

A part of the second collimation region 105b that receives the first part 108a of the second optical beam 108 and the second part 107b of the first optical beam 107, for example, the part of the second collimation region 105b where said parts overlap, may be configured to collimate both of said parts 108a, 107b of the optical beams 107, 108.

Further, FIG. 3 shows that the first part 107a of the first optical beam 107 and the second part 107b of the first optical beam 107 are combined into at least a part of a first collimated optical beam 109, and that the first part 108a of the second optical beam 108 and the second part 108b of the second optical beam 108 are combined into at least a part of a second collimated optical beam 110.

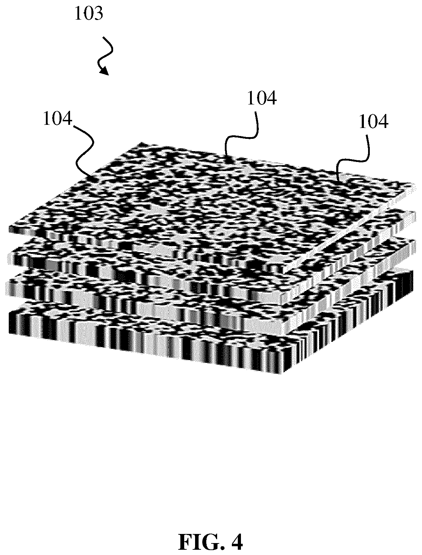

FIG. 4 shows an exemplary metamaterial 103 according to this disclosure. FIG. 4 shows exemplary materials of the at least two distinct materials, wherein Si₃N₄ is shown in grey and TiO₂ is shown in black. The disclosure and scope of the claims is however not limited thereto, the skilled person will recognize there exist other materials systems/combinations that can be used to obtain the same effect. The distribution formed by the subwavelength structures in each collimation region may be irregular as shown in the exemplary distribution of FIG. 4. The distribution may comprise tuned periodicities for the two or more optical beams.

In this example the metamaterial 103 comprises four layers, wherein the distribution of the plurality of subwavelength structures 104 was formed based on a machine learning algorithm. A computer implemented algorithm, for example, a machine learning algorithm, may consider the requirements for collimating respective parts of optical beams that are supposed to be collimated by the metamaterial 103 at each positions and determine the distribution of the plurality of subwavelength structures 104 in the metamaterial 103 based on said requirements.

The metamaterial 103 may be considered to be an implementation of partially overlapping lenses, each lens forming a collimated optical beam from an associated set of adjacent emission pixels, each pixel emitting an optical beam of a unique wavelength, each lens thereby forming a collimated optical beam for that specific wavelength of the optical beam.

The disclosure has been described in conjunction with various embodiments as examples as well as implementations. However, other variations can be understood and effected by those persons skilled in the art and practicing the claimed matter, from the studies of the drawings, this disclosure and the independent claims. In the claims as well as in the description the word "comprising" does not exclude other elements or steps and the indefinite article "a" or "an" does not exclude a plurality. A single element or other unit may fulfill the functions of several entities or items recited in the claims. The mere fact that certain measures are recited in the mutual different dependent claims does not indicate that a combination of these measures cannot be used in an advantageous implementation.

## Claims

1. An integrated optical system (100) comprising:
an array of emission pixels (101), each emission pixel (101) being configured to emit a respective optical beam having a respective wavelength,
a controller (102) configured to control the array of emission pixels (101) to emit two or more optical beams (106) by using two or more emission pixels (101), and
an optical metamaterial (103) having a plurality of subwavelength structures (104),
wherein the plurality of subwavelength structures (104) comprises at least two distinct materials having different refractive indices,
wherein the optical metamaterial (103) comprises a plurality of collimation regions (105), each collimation region being associated with one respective emission pixel of the array of emission pixels (101),
wherein the plurality of collimation regions (105) are arranged to receive the two or more optical beams (106) from the array of emission pixels (101), and
wherein a first collimation region (105a) of the plurality of collimation regions (105) is configured to collimate respectively a first part (107a) of a first optical beam (107) of the two or more optical beams (106) and a second part (108b) of a second optical beam (108) of the two or more optical beams (106) by diffracting the first part (107a) of the first optical beam (107) and the second part (108b) of the second optical beam (108) based on a distribution of the plurality of subwavelength structures (104) in the first collimation region (105a),
wherein a second collimation region (105b) of the plurality of collimation regions (105) is configured to collimate respectively a second part (107b) of the first optical beam (107) and a first part (108a) of the second optical beam (108) by diffracting the second part (107b) of the first optical beam (107) and the first part (108a) of the second optical beam (108) based on a distribution of the plurality of subwavelength structures (104) in the second collimation region (105b),
wherein the first part (107a) of the first optical beam (107) and the second part (107b) of the first optical beam (107) are thereby combined to form at least a part of a first collimated optical beam (109),
wherein the first part (108a) of the second optical beam (108) and the second part (108b) of the second optical beam (108) are thereby combined to form at least a part of a second collimated optical beam (110), and
wherein the first optical beam (107) and the second optical beam (108) have different respective wavelengths.

2. The optical system (100) according to claim 1,
wherein each collimation region of the plurality of collimation regions (105) is centered above the respective emission pixel that is associated with the collimation region.

3. The optical system (100) according to claim 1 or 2,
wherein the first optical beam (107) is emitted from a respective emission pixel (101a) that is associated with the first collimation region (105a),
wherein the second optical beam (108) is emitted from a respective emission pixel (101b) that is associated with the second collimation region (105b), and
wherein the respective emission pixel (101b) that is associated with the second collimation region (105b) is adjacent to the respective emission pixel (101a) that is associated with the first collimation region (105a).

4. The optical system (100) according to any one of the preceding claims,
wherein the plurality of collimation regions (105) are arranged such that, for each emission pixel of the array of emission pixels (101), the respective optical beam emitted by the respective emission pixel is primarily collimated by the collimation region that is associated with the respective emission pixel.

5. The optical system (100) according to any one of the preceding claims,
wherein the plurality of collimation regions (105) are arranged such that the first part (107a) of the first optical beam (107) and the second part (108b) of the second optical beam (108) have different angles of incidence on the first collimation region (105a).

6. The optical system (100) according to any one of the preceding claims,
wherein the distribution of the plurality of subwavelength structures (104) in the first collimation region (105a) and/or the refractive indices of the at least two distinct materials is/are configured based on estimated respective angles of incidence of the first part (107a) of the first optical beam (107) and the second part (108b) of the second optical beam (108) on the first collimation region (105a).

7. The optical system (100) according to any one of the preceding claims,
wherein the distribution of the plurality of subwavelength structures (104) in the first collimation region (105a) and/or the refractive indices of the at least two distinct materials is/are configured based on the respective wavelengths of the first optical beam (107) and the second optical beam (108).

8. The optical system (100) according to any one of the preceding claims,
wherein the distribution of the plurality of subwavelength structures (104) in the first collimation region (105a) is irregular, or
wherein the distribution of the plurality of subwavelength structures (104) in the first collimation region (105a) comprises two or more different periodicities.

9. The optical system (100) according claim 8,
wherein a first periodicity of the two or more different periodicities of the first collimation region (105a) is configured based on the first part (107a) of the first optical beam (107), and
wherein a second periodicity of the two or more different periodicities of the first collimation region (105a) is configured based on the second part (108b) of second optical beam (108).

10. The optical system (100) according to any one of the preceding claims,
wherein the first collimation region (105a) is arranged to receive only the first part (107a) of the first optical beam (107) and only the second part (108b) of the second optical beam (108).

11. The optical system (100) according to any one of the preceding claims,
wherein the plurality of collimation regions (105) are arranged abuttingly.

12. The optical system (100) according to any one of the preceding claims,
wherein at least one of:
a thickness of the metamaterial (103) is in a range of 0.1 to 10 times a wavelength of each of the two or more optical beams (106); and
a size of each subwavelength structure of the plurality of subwavelength structures (104) is in a range of 10 nm to 1000 nm.

13. The optical system (100) according to any one of the preceding claims,
wherein the metamaterial (103) comprises two or more layers comprising the plurality of subwavelength structures (104).

14. The optical system (100) according to claim 13,
wherein each layer is thinner than each other layer that is closer to a side of the metamaterial (103) that is arranged to receive the two or more optical beams (106).

15. The optical system (100) according to any one of the preceding claims,
wherein one or more surfaces of the metamaterial (103) that face away from the array of emission pixels (101) define a plane having a normal vector,
wherein the distribution of the plurality of subwavelength structures (104) in the first collimation region (105a) and/or the refractive indices of the at least two distinct materials is/are configured such that the first collimated optical beam (109) is provided from the metamaterial (103) at an angle to the normal vector that is larger than 0°.
